(19)

Europäisches Patentamt

European Patent Office

Office européen des brevets

(11) **EP 4 261 905 B1**

(12) **EUROPEAN PATENT SPECIFICATION**

(45) Date of publication and mention
of the grant of the patent:
**26.03.2025 Bulletin 2025/13**

(21) Application number: **22168493.9**

(22) Date of filing: **14.04.2022**

(51) International Patent Classification (IPC):
**H10N 70/20** *(2023.01)*     **H10N 70/00** *(2023.01)*
**H10N 79/00** *(2023.01)*

(52) Cooperative Patent Classification (CPC):
**H10N 70/231; H10N 70/823; H10N 70/8613;
H10N 79/00**

(54) **PHASE CHANGE MATERIAL SWITCH DEVICE AND RELATED METHOD**

SCHALTVORRICHTUNG FÜR PHASENWECHSELMATERIAL UND ZUGEHÖRIGES VERFAHREN

DISPOSITIF DE COMMUTATION DE MATÉRIAU À CHANGEMENT DE PHASE ET PROCÉDÉ
ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.10.2023 Bulletin 2023/42**

(73) Proprietor: **Infineon Technologies AG
85579 Neubiberg (DE)**

(72) Inventors:
 • **WOHLMUTH, Hans-Dieter
   81673 München (DE)**

 • **HEISS, Dominik
   80799 München (DE)**
 • **SOLOMKO, Valentyn
   81479 München (DE)**

(74) Representative: **Kraus & Lederer PartGmbB
Thomas-Wimmer-Ring 15
80539 München (DE)**

(56) References cited:
 **US-A1- 2010 163 832    US-B1- 10 461 253
 US-B1- 9 917 104**

**Description**

TECHNICAL FIELD

The present application relates to phase change material (PCM) switch devices, sometimes also simply referred to as phase change switch devices, and to corresponding methods. The technical requirements for radio frequency (RF) applications using high frequencies, such as radar sensing and mobile communication according to the 5G standard, are increasing. In particular, switches having improved characteristics compared to state-of-the-art CMOS switches will be required to meet future demands. Phase change switches are considered as promising candidates for switching RF signals. Such phase change switches use a phase change material (PCM) which typically exhibits a higher electric conductivity in a crystalline phase state than in an amorphous phase state. By changing the phase state of the phase change material, a switch device including such a material may be switched on and off.

For example, to change the phase state from amorphous to crystalline, typically a heater is employed heating the phase change material causing crystallization. This switching on by causing crystallization is also referred to as a set operation. In the set operation, the heater is actuated in such a way that the temperature of the phase change material is above its crystallization temperature, typically about 250°C, but below the melt temperature typically in a range of 600°C to 900°C, for example. The length of the heating pulse caused by the heater is chosen such that any amorphous portion present in the PCM can regrow into the crystalline phase state.

When switching off the switching device, also referred to as reset operation, the heater is actuated in such a way that the temperature of the PCM is raised above the melt temperature (for example above about 600°C to 900°C) followed by a comparatively rapid cooldown which freezes the phase change material or at least a portion thereof into an amorphous state.

Suitable phase change materials used for such phase change switches include germanium telluride (GeTe) or germanium-antimony-tellurium (GeSbTe, usually referred to as GST), and heaters may be made of a material like polycrystalline silicon or tungsten.

PCM switch devices promise excellent radio frequency performance in comparison to state of the art CMOS RF switches. In particular, the main figure of merit, the product of on-resistance and off capacitance, is reduced significantly from around 80 fsec for CMOS RF switches to values below 20 fsec for PCM switch devices.

In particular, a low off capacitance is desirable in applications like antenna tuning, as resonant modes of tuning networks including such switches may adversely influence the antenna properties at a high operating frequency.

For example, when for tuning purposes such a PCM switch is coupled in series to an inductor having an inductance L, the off state capacitance $C_{OFF}$ of the switch creates a series resonance at a frequency $f_{res} = \frac{1}{2\pi\sqrt{L\,C_{OFF}}}$. This resonance frequency must be shifted to a value outside the operating frequency range of the respective system, for example radio frequency antenna, by either minimizing the inductance value L or minimizing $C_{off}$. The latter option is preferred, as it offers a higher degree of freedom in choosing the tuning elements, in particular inductances thereof, of a system.

US 9 917 104 B1 discloses a phase change switch device with a conventional heater and tuning transistors. Such a device is also disclosed in US 10 461 253 B1, where a heat valve is provided below the heater and a so-called nugget is placed between the heater and a phase change material for electrical isolation and thermal coupling.

US 2010/0163832 A1 discloses a phase change memory with a heater.

SUMMARY

A phase change material switch device as defined in claim 1 and a method as defined in claim 14 are provided. The dependent claims define further embodiments.

According an embodiment, a phase change material switch device is provided, comprising:

> a phase change material, and
> a heater device thermally coupled to the phase change material.

The heater device is configured to:

> have a first electrical resistance in a first state where current is applied to the heater device for heating the phase change material, and
> have a second electrical resistance higher than the first electrical resistance in a second state outside heating phases of the heater device.

According to another embodiment, a method of operating a phase change material switch device is provided, the phase change material switch device comprising a phase change material and a heater device thermally coupled to the phase change material, the method comprising:

switching a state of the phase change switch device by setting the heater device to a first state with a first electrical resistance and providing current through the heater device for heating the phase change material, and setting the heater device to a second state with a second electrical resistance higher than the first electrical resistance outside heating phases of the heater device.

The above summary is merely intended as a brief overview over some embodiments and is not to be construed as limiting in any way, as other embodiments may include different features from the ones listed above.

BRIEF DESCRIPTION OF THE DRAWINGS

Fig. 1 is a block diagram of a phase change material switch device according to an embodiment.

Fig. 2A is a top view of a phase change material switch device used for comparison purposes, and Fig. 2B is a cross-sectional view thereof.

Fig. 3 is an equivalent circuit illustrating capacitances in the phase change material switch device of Figures 2A and 2B.

Fig. 4A is a top view of a phase change material switch device according to an embodiment, and Fig. 4B is a cross-sectional view thereof.

Fig. 5A is a top view of a phase change material switch device according to an embodiment, and Fig. 5B is a cross-sectional view thereof.

Fig. 6A is a top view of a phase change material switch device according to an embodiment, and Fig. 6B is a cross-sectional view thereof, and Fig. 6C illustrates controlling of a heater of the embodiments of Figures 5A, 5B, 6A or 6C.

Fig. 7A is a cross-sectional view of a phase change material switch device according to a further embodiment, and Fig. 7B illustrates heater control thereof.

Fig. 8 is a top view of a phase change material switch device for illustrating overlaps.

Fig. 9A is a first cross-sectional view of a phase change material switch device according to a further embodiment, and Fig. 9B is a second cross-sectional view thereof.

Fig. 10A is a first cross-sectional view of a phase change material switch device according to a further embodiment, and Fig, 10B is a second cross-sectional view thereof.

Fig. 11A is a first cross-sectional view of a phase change material switch device according to further embodiment, and Fig. 11B is a second cross-sectional view thereof.

Fig. 12A is a first cross-sectional view of a phase change material switch device according to an embodiment, and Fig. 12B is a second cross-sectional view thereof.

Fig. 13 is a cross-sectional view of a phase change material switch device according to a further embodiment.

Fig. 14 is a flow chart illustrating a method according to some embodiments.

Fig. 15 is a flow chart illustrating a method according to some embodiments.

Fig. 16 is a diagram illustrating an application environment for phase change material switch devices according to various embodiments.

DETAILED DESCRIPTION

In the following, various embodiments will be described in detail referring to the attached drawings. The embodiments described hereinafter are to be taken as examples only and are not to be construed as limiting. For example, while in embodiments specific arrangements or components are provided, in other embodiments other configurations may be used.

Implementation details described with respect to one of the embodiments are also applicable to other embodiments. Features from different embodiments may be combined to form further embodiments.

Variations and modifications described for one of the embodiments may also be applied to other embodiments and will therefore not be described repeatedly.

In the Figures, like elements are designated with the same reference numerals. Such elements will not be described repeatedly in each Figure to avoid repetitions. Any directional terminology used when referring to the drawings (e.g. up, down, left, right) is merely for indicating elements and directions in the drawings and is not intended to imply a directional orientation of the actually implemented devices.

Besides features (for example components, elements, acts, events or the like) explicitly shown and described, in other embodiments additional features may be provided, for example features used in conventional switch devices using phase change materials. For example, embodiments described herein relate to equalization devices in phase change material (PCM) switch devices, and other components and features, like spatial arrangement of heaters and phase change material, radio frequency (RF) circuitry using the switch device and the like may be implemented in a conventional manner. Such RF circuitry may be integrated with the described switch devices on the same substrate, but may also be provided separately for example, on one or more separate chip dies, which in some implementations then may be combined with a switch device in a common package. Also, manufacturing implementations like providing phase change material on a substrate like a silicon substrate to implement a PCM switch device or in a part thereof like a trench for manufacturing the switch device and the like may be performed in any conventional manner.

A switch based on a phase change material (PCM) will be referred to as a phase change switch (PCS) or PCM switch herein. As explained in the introductory portion, such phase change switches may be set to a crystalline phase state or an amorphous phase change, thus changing the resistance of the phase change material and therefore of the switch by several orders of magnitude. In this way, for example an on-resistance of a switch in a range of 1 to 100 $\Omega$ may be achieved, whereas an off-resistance may be several orders of magnitude higher, for example at least in the Kiloohm range.

PCM switch devices discussed herein may be manufactured for example in layer deposition and patterning processes similar to those used in semiconductor device manufacturing, by depositing or modifying layers on a substrate. In some embodiments discussed herein, cross-sectional views and top views are illustrated. A cross-sectional view essentially corresponds to a cross section through the substrate, whereas a top view is a view in a direction towards a surface of the substrate.

While phase change switch devices in the embodiment below are shown with a configuration where a heater is provided below a phase change material, in other embodiments the heater may be provided above the phase change material. Furthermore, currents through the phase change material and through the heater may run in the same direction or in different, for example perpendicular directions. Therefore, the specific configurations shown are not to be construed as limiting in any way.

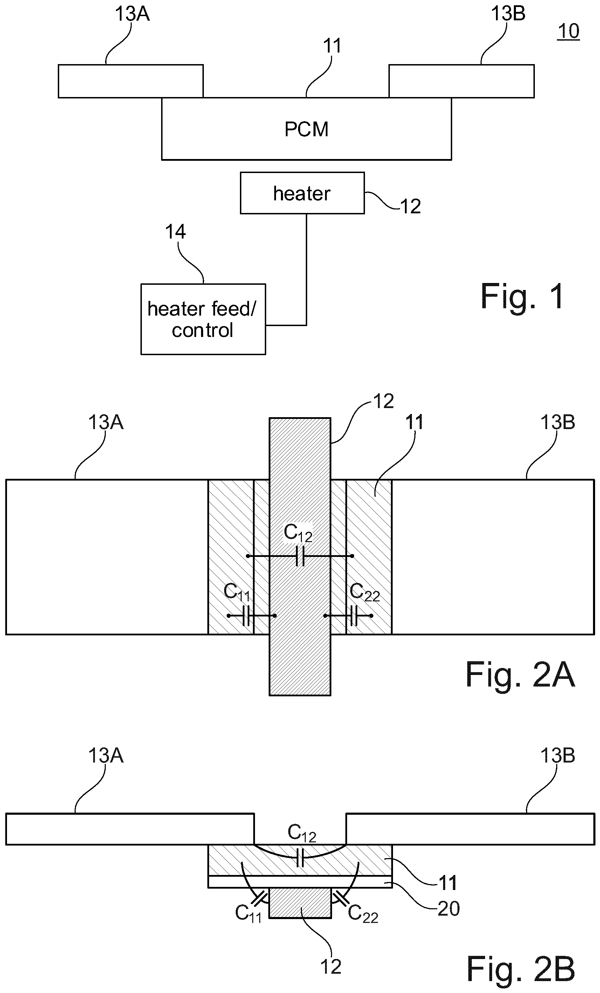

Turning now to the Figures, Fig. 1 illustrates a phase change material switch device, PCM switch device 10 according to an embodiment. PCM switch device 10 includes a phase change material 11, contacted by electrodes 13A, 13B. A heater 12 is placed adjacent to phase change material 11, electrically isolated but thermally coupled to phase change material 11. By heating phase change material 11 using heater 12, as in conventional PCM switch devices, phase change material 11 may be selectively set to a crystalline, electrically conducting state or to an amorphous, electrically isolating state. It should be noted that in the amorphous state phase change material 11 need not become fully amorphous, but some crystalline portions may remain for example in the vicinity of electrodes 13A, 13B, as long as the phase change material in the amorphous state provides an electrical isolation between electrodes 13A and 13B. Phase change material 11 may be any suitable phase change material described in the introductory portion.

Heater 12 is controlled and supplied with power by a heater feed/control entity 14. Heater 12, controlled by entity 14, may at least be in a first state or in a second state, which does not exclude further states being possible. In a first state, the heater has a first electrical resistance suitable for heating. This state, in other words, is used for heating phase change material 11 to perform a set or a reset operation as explained in the introductory portion, by feeding current through the heater. The first electrical resistance in the first state is such that heat is generated by dissipation of electrical power.

In the second state, heater 12 is configured to have a second electrical resistance higher than the first electrical resistance in the first state. For example, the first electrical resistance may be 500$\Omega$ or less , 100$\Omega$ or less or 50$\Omega$ or less and the second electrical resistance may be at least 100 times higher than the first electrical resistance, for example at least 500 times higher or about 1000 times higher, for example 10k$\Omega$ or higher. Higher resistances like about 500$\Omega$ may for example occur in a hot state of the heater, where the heating increases the resistance. In some cases, in the second state the heater may be essentially electrically insulating. The second state may be used outside heating phases of the heater device, for example generally outside the heating phases or at least in a switched-off state of the PCM switch device 10. In some embodiments, this may reduce a parasitic capacitance between electrodes 13A, 13B and heater 12 in an off state of PCM switch device 10. This will now be explained in more detail referring to Figures 2 (including subfigures 2A and 2B), 3 and 4 (including Subfigures 4A and 4B).

Fig. 2A shows a top view of a PCM switch device according to a comparative example, and Fig. 2B shows a cross-section thereof in a horizontal direction of Fig.2A.

The PCM switch device of Fig. 2 includes phase change material 11, electrodes 13A, 13B and heater 12 as already explained referring to Fig. 1. An electrically insulating but thermally conducting layer 20 is provided between heater 12 and phase change material 11 to provide thermal coupling and electric isolation.

In the comparative example of Figures 2A and 2B, heater 12 is a conventional heater which always has a comparatively low electrical resistance, for example below 50$\Omega$, irrespective of a state the phase change switch device is in.

For an off state of the phase change switch device, parasitic capacitances are shown in Figures 2A and 2B. $C_{12}$ is a parasitic capacitance between first electrode 13A and second electrode 13B, $C_{11}$ is a parasitic capacitance between first electrode 13A or a part of phase change material 11 close to electrode 13A remaining electrically conducting and heater 12, and $C_{22}$ is a similar capacitance between electrode 13B or a electrically conducting portion of phase change material 11 adjacent to electrode 13B and heater 12. In other words, as heater 12 is electrically conducting also in the off state, it effectively acts as a capacitor plate. In case the switch is on and phase change material 11 is electrically conducting, still parasitic capacitances remain between phase change material 11 and heater 12, with layer 20 serving as electrically isolating layer therebetween.

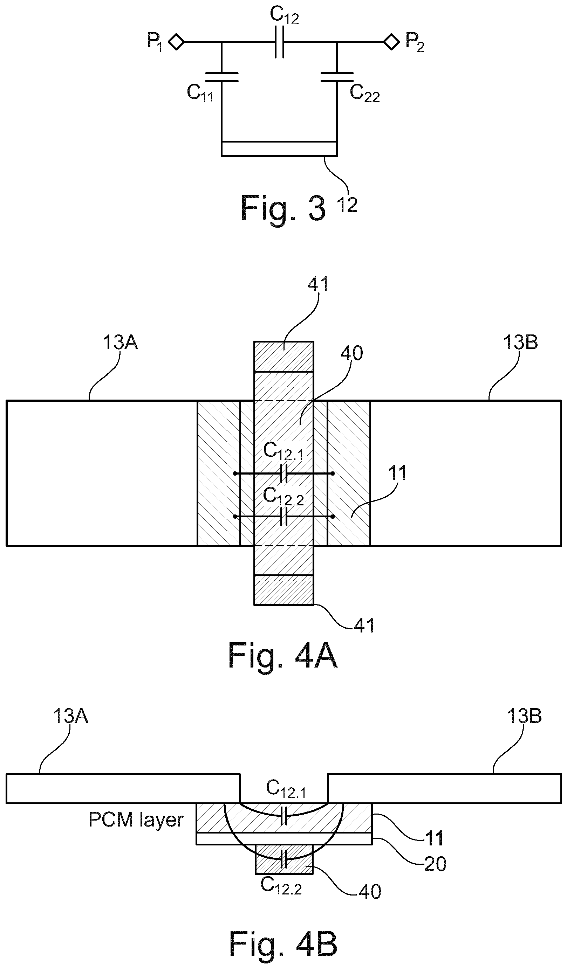

Fig. 3 shows an equivalent circuit illustrating the parasitic capacitances discussed above with respect to Fig. 2A and 2B in an equivalent circuit diagram. $P_1$ and $P_2$ are terminals corresponding to the first and second electrodes 13A, 13B, respectively.

As mentioned above, in some applications like antenna tuning applications, it is desirable to reduce the off capacitance as much as possible.

Figures 4A and 4B show a phase change device according to an embodiment in an off state, Fig. 4A showing a top view and Fig. 4B showing a cross-sectional view, similar to the comparative example of Figures 2A and 2B. Here, the heater is in the second state above, illustrated as having a high ohmic resistance(e.g. electrically insulating) portion 40 with electrical contact portions 41. This leads to a "replacement" of parasitic capacitances $C_{11}$, $C_{22}$ of Figures 2A, 2B and 3 with a capacitance $C_{12,2}$ in parallel to the capacitance $C_{12}$ of Figures 2A, 2B and 3, which in Figures 4A and 4B is labelled $C_{12,1}$. $C_{12,2}$ is lower than the series connection of $C_{11}$ and $C_{22}$ via heater 12 shown in Figures 2A, 2B and 3, such that the overall capacitance is lower.

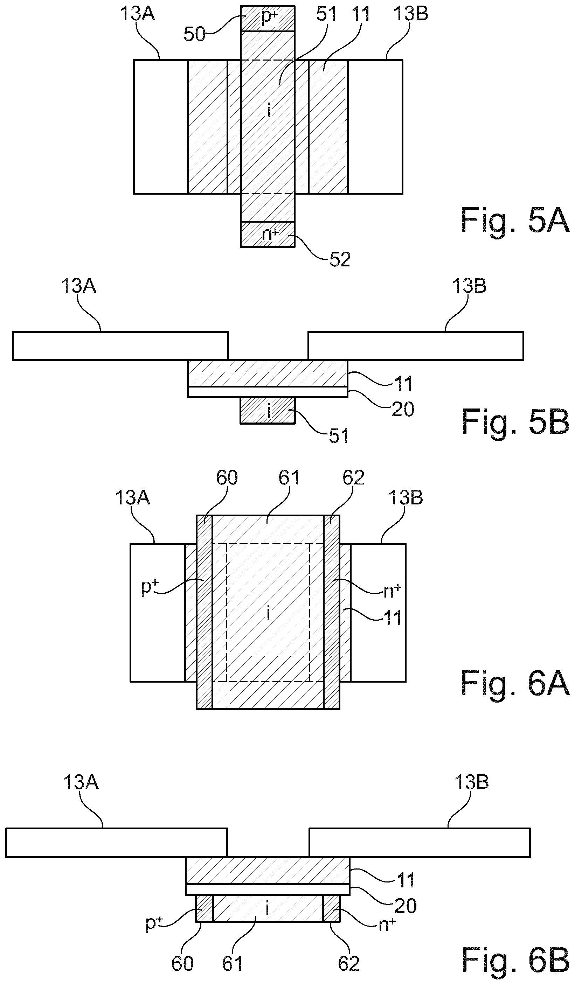

Next, various implementation examples of a heater that may change between the first state and the second state will be discussed. First, with reference to Figures 5 (including Subfigures 5A and 5B) and 6 (including Subfigures 6A to 6C) an implementation using a pin diode is shown.

Fig. 5A shows a top view of a PCM switch device according to an embodiment, and Fig. 5B shows a side view thereof. In the embodiment of Figures 5A and 5B, the heater is formed by a pin diode including a highly p-doped (p+) portion 50, a highly n-doped (n+) portion 52 and an intrinsic (i), i.e. nominally undoped or lightly doped, portion therebetween. Highly doped portions may have a resistivity smaller than $10\Omega$ x cm or dopant concentrations greater than $1 \times 10^{18}/cm^3$, whereas lightly doped portions, for example the intrinsic portions above, may have a resistivity smaller than $100\Omega$ x cm and a dopant concentration smaller than $1 \times 10^{18}/cm^3$, for example smaller than $1 \times 10^{17}/cm^3$.

In the top view of Fig. 5A, intrinsic portion 51 extends over the complete phase change material 11, and portions 50, 52 are outside the phase change material 11 in the top view. In the embodiment of Figures 5A and 5B, current flows through the phase change material 11 and therefore through the switch device in an on-state essentially from left to right in the view of Figures 5A and 5B, and through the heater from top to bottom in Fig. 5A or perpendicular to the drawing plane of Fig. 5B.

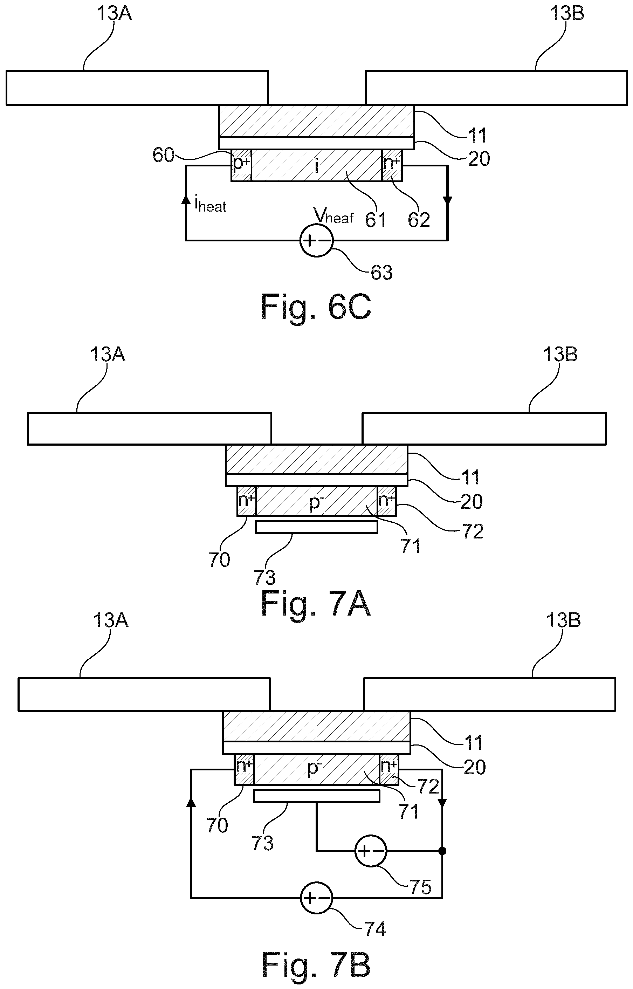

As will be further explained below referring to Fig. 6C, in the first state mentioned above, for heating of a phase change material 11 the pin diode 50, 51, 52 is forward biased above the threshold voltage, such that a current flows with relatively low resistance. In the second state mentioned above, i.e. outside heating, the pin diode is reversed bias, leading to a depletion portion essentially without free carriers and therefore correspondingly high ohmic resistance.

Figures 6A and 6B show a variation of the embodiment of Figures 5A and 5B. Also in case of Figures 6A and 6B, the heater is provided as a pin diode, here including a highly p-doped portion 60, an intrinsic portion 61 and a highly n-doped portion 62. In contrast to Fig. 5A and 5B, the orientation of the pin diode is rotated by 90° in the top view of Figures 6A, such that the current flow through the heater when heating phase change material 11 and the current flow through the phase change material from electrode 13A to 13B in an on-state are essentially in the same direction, from left to right in Figures 6A and 6B.

Fig. 6C shows an example control for the PCM switch device of Figures 6A and 6B. An adjustable voltage source 63 supplies the heater 60, 61, 62. For heating, as shown in Fig. 60 the pin diode forming the heater is forward biased, such that a heater flow $i_{heat}$ flows, causing heat generation and heating of phase change material 11. Outside heating the polarity of voltage source 63 is reversed, such that the pin diode is reversed bias and a depletion portion is formed as explained above. Voltage source 63 in this case is an example for heater feed/control entity 14 of Fig. 1.

Heaters as used herein are not restricted to pin diodes. Figures 7A and 7B illustrate a device according to a further embodiment, where Fig. 7A illustrates a cross-section of the device, and Fig. 7B illustrates an example control of the heater of Fig. 7A.

In Fig. 7A, the heater is provided as an electrostatically controlled heater similar to a field effect transistor (FET), where the heater includes highly n-doped portions 70, 72 with a lightly p-doped portion 71 in between. In other embodiments, the polarity may be reversed, i.e. two p-doped portions with a n-doped portion in between. Furthermore, the heater includes a control electrode 73. This control electrode 73 operates similar to a gate electrode of a field effect transistor, and by applying an appropriate voltage to control electrode 73 as a control signal the resistance of the heater can be changed between the first and second states mentioned above.

It should be noted that also here, the heater may be provided rotated by 90° in a top view, as explained above with reference to Figures 5 and 6 for the pin diode.

Fig. 7B illustrates an example control. A first voltage/current source 74 is used to apply a heating current for heating the heater and therefore phase change material 11. A second voltage source 75 is configured to apply a control voltage to control electrode 73 with respect to p-doped portion 72, corresponding to applying an appropriate gate force voltage in conventional field effect transistors. By modifying the voltage, the heater may be set to a high ohmic state (second state above) outside heating phases or a low ohmic state (first state above) during heating. Voltage/Current source 74 and voltage source 75 are a further example for heater feed/control entity 13 of Fig. 1.

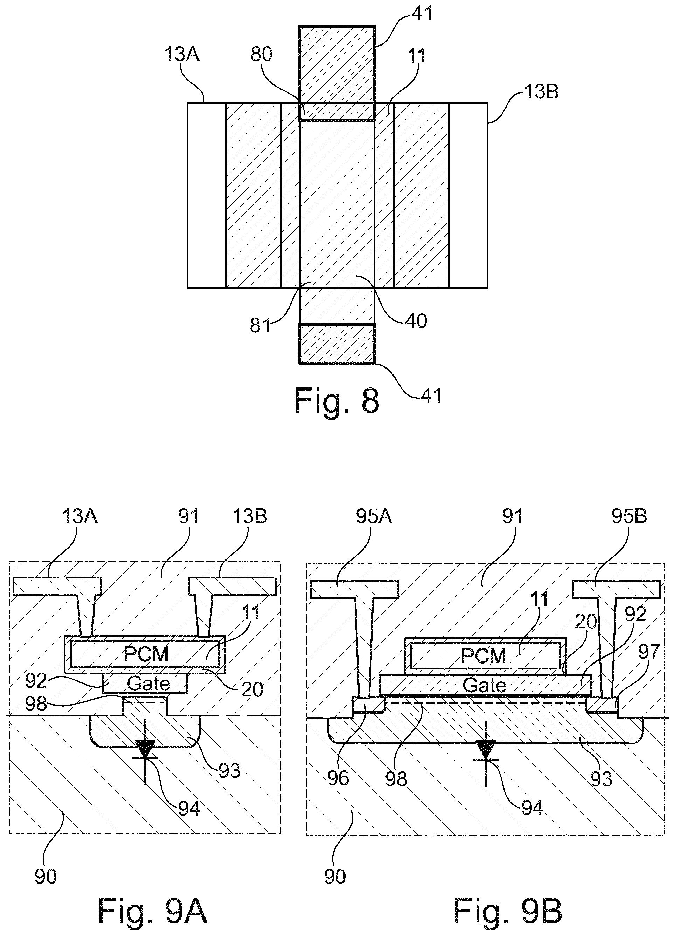

As already briefly mentioned for Fig. 5A, in the second state of the heater with the high resistance, in some embodiments the portion of the heater having the high resistance (depletion portion in case of a pin diode or also in case of the field effect transistor like arrangement in Fig. 7, as well as for some embodiments described further below), overlaps with the phase change material in a top view, while electrically conducting portions like electrodes, highly doped portions or the like do not overlap with the phase change material, in order to further reduce the capacitance. This concept of overlap is further illustrated in Fig. 8.

Fig. 8 shows a heater corresponding to the heater of Fig. 4A, with an electrically isolating portion 40 which, in Figures 5 to 7 may correspond to the intrinsic portion in case of the pin diode or the lightly p doped portion for the field effect transistor like implementation, and conducting portions 41 correspond to the highly p- or n-doped portions. In the top view of Fig. 8, at 80 an overlap exists between the top electrode 41 and phase change material 11, or at least with portions of the phase change material that are turned amorphous in the switched off state, whereas for the lower electrode 41, at 81, no overlap exists. As mentioned above, in some embodiments such an overlap is avoided altogether avoided (as explained e.g. for Figs. 5A and 5B) to further decrease the parasitic capacitance. It should be noted in the rotated arrangement of Figs. 6A and 6B, electrode 41 may e.g. overlap with electrode 13A, 13B in the top view.

In Figures 7A and 7B, a field effect transistor like heater was illustrated. Further configurations of field effect transistors usable as heaters, as well as contacting thereof, will now be described referring to Figures 9 to 13, where Figures 9, 10, 11 and 12 each include subfigures A and B. Subfigure A in each case shows a cross-sectional view in a first direction, and subfigure B shows a cross-sectional view in a second direction perpendicular to the first direction. For example, given the top views discussed previously, the respective subfigure A may be a cross-section from left to right in the top view, and subfigure B may be a cross-section from top to bottom of the top view.

Fig. 9 shows an embodiment of a PCM switch device having a field effect transistor as a heater. The PCM switch device of Fig. 9 is formed on a substrate 90, for example a lightly n-doped semiconductor substrate. A p-doped portion 93 is formed in substrate 90. N-doped source and drain portions 96, 97 are also formed. Separated from portion 93 by a gate oxide, a gate electrode 92 is formed, for example made of metal or polysilicon. Separated from gate electrode 92 by electrically insulating but thermally conducting material 20, the phase change material 11 is deposited. Electrodes 13A, 13B are formed for contacting phase change material 11, and electrodes 95A, 95B are formed for contacting source and drain portions 96, 97, respectively. An additional electrode (not shown in Figures 9A and 9B) is formed for electrically contacting the gate electrode 92. The structure is enclosed in a dielectric material 91, for example silicone dioxide. Formation of the structure of Figures 9A and 9B, as with previously discussed PCM devices, may use conventional semiconductor process techniques for depositing the various components in layers (for example the electrodes in metal layers), and/or using doping techniques like diffusion doping or ion implantation to form the portion.

In the first state, for heating the phase change material, electrode 92 is controlled such that an n channel indicated by a dashed line 98 is formed through which current can flow from electrode 95A to electrode 95B, causing heat generation and heating of phase change material 11.

In the second state outside the heating, the gate may be controlled to cause a high electric resistance between source and drain terminals 96, 97. In some embodiments, the transistor may be a normally off transistor, such that when no voltage is applied the gate electrode, the transistor is in an off state corresponding to the second state having a high resistance.

Reference numeral 94 illustrates a parasitic body diode of the transistor, formed between p-doped portion 93 and substrate 90.

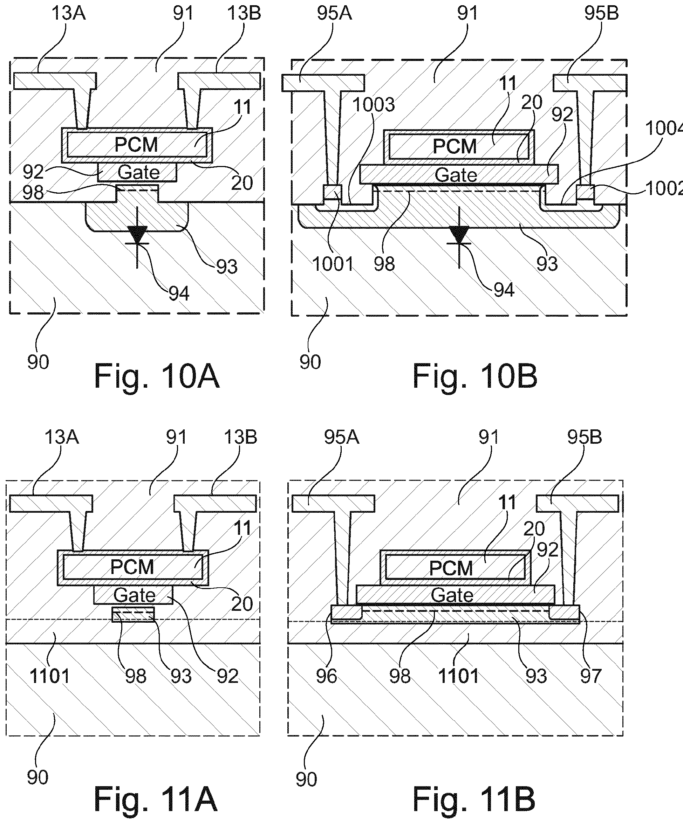

Fig. 10 illustrates a variation of the embodiment of Fig. 9. Fig. 10A shows a cross-sectional view corresponding to the view of Fig. 9A, and Fig. 10B shows a cross-sectional view corresponding to the cross-sectional view of Fig. 9B.

Compared to the embodiment of Figures 9A and 9B, as best seen in Fig. 10B the source and drain terminals are modified and include highly n-doped portions 1001, 1002, respectively, and lower doped n-type doped portions 1003, 1004 having a thin somewhat L-shaped shape in cross-section as shown in Fig. 10B. Portions 1003, 1004 may have a similar doping as substrate 90 or may in part B made of substrate 90 in a manufacturing process. The configuration of Fig. 10 compared to the configuration of Fi. 9, may lead to a higher voltage capability of the source and drain terminals versus the gate terminals, i.e. higher voltages may be applied to the PCM switch device for example in an off state.

Figures 11A and 11B illustrate a further modification of the embodiment of Fig. 9, where Fig. 11A shows a cross-sectional view corresponding to Fig. 9A and Fig. 11B shows a cross-sectional view corresponding to Fig. 9B. Here, instead of a normal substrate like a normal silicone substrate 90 a silicon on insulator (SOI) substrate is used, including substrate 90 and silicon dioxide layer 1102. The devices are then formed on a silicon layer (as a layer not shown in Figures 11A and 11B, or removed during the processing) on top of silicon dioxide layer 1101. In this case no bulk diode 94 is formed, which in some cases may improve the high frequency behavior of the switch device.

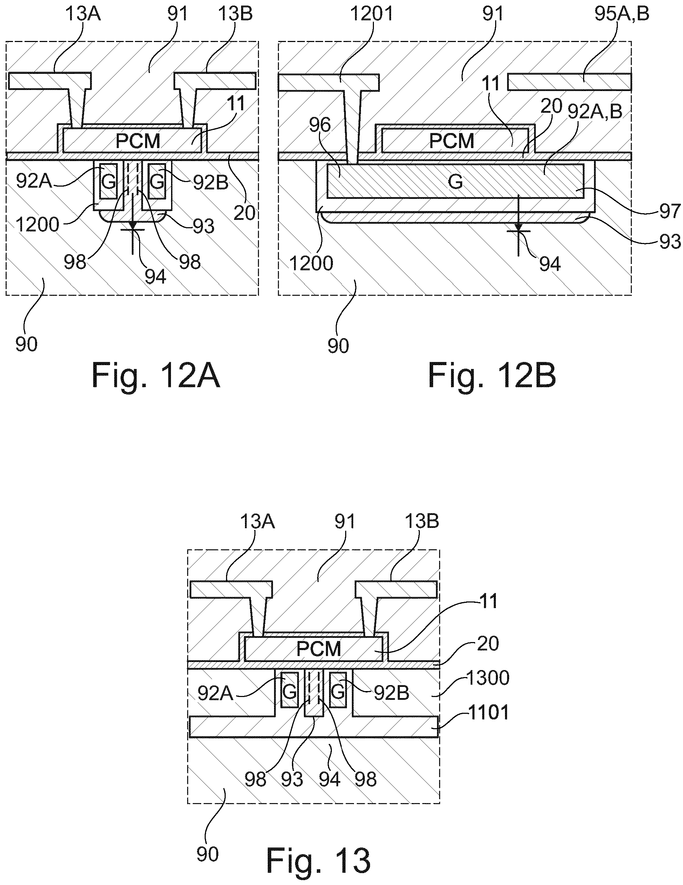

The embodiments of Figures 9 to 11 show planar field effect transistor devices. In other embodiments, as a heater a field effect transistor may be provided in a trench within a substrate. Corresponding embodiments will now be described referring to Figures 12 and 13, Fig. 12 including Subfigures 12A and 12B.

In Figures 12A, 12B, a trench field effect transistor is provided in a trench formed in substrate 90. Gate electrodes 92A, 92B in the cross-section of Fig. 12A are formed on two sides of p-doped portion 93, leading to the formation of two n-channels in a switched on state for heating as indicated by dashed lines 98. Current trough the heater flows in a horizontal direction in the view of Fig. 12B or perpendicular to the drawing plane of Fig. 12A. Electrodes 1201, of which one is shown in Fig. 12B, contact gate electrodes 92A, 92B, and electrodes 95A, 95B as schematically shown contact source and drain portions, which are not explicitly shown in Figures 12A and 12B. With the arrangement in a trench, the gate electrode is not interposed between the phase change material and the N-channel when heating. Simulations have shown that this may lead to an advantageous heat distribution from heating phase change material 11.

Fig. 13 illustrates a variation of the embodiment of Fig. 12 provided on a silicon on insulator substrate including the bulk substrate 90, silicon dioxide layer 1101 and a silicon layer 1300 on top of silicon dioxide layer 1101.

The field effect transistor is provided in a trench within layer 1300. Otherwise, the configuration corresponds to the configuration of the trench transistor of Fig. 12. Similar to Fig. 11, also here no bulk diode is present.

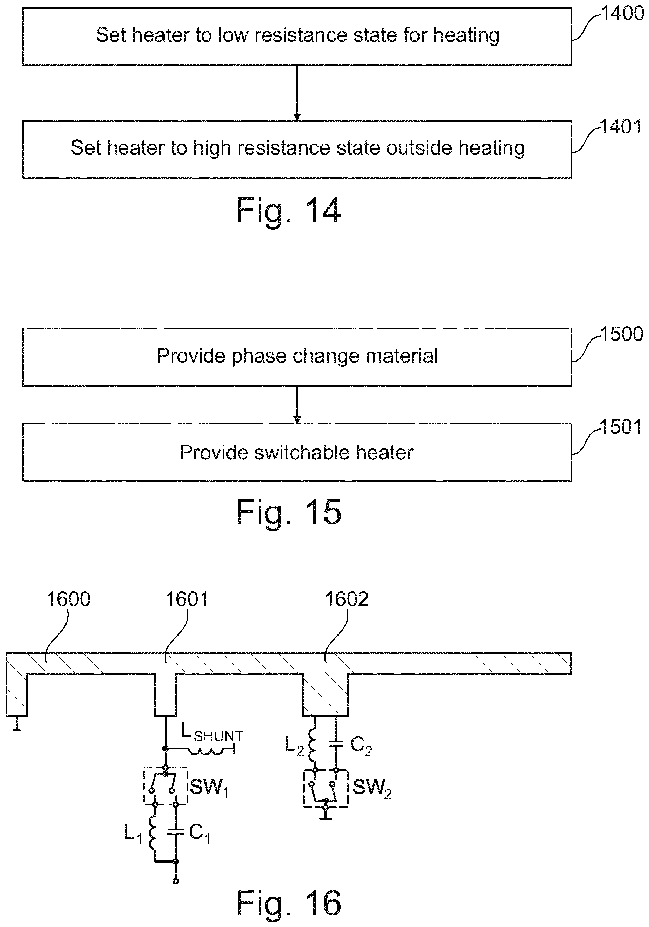

Fig. 14 is a flow chart illustrating a method according to an embodiment, which may be used for operating the PCM switch devices of any of the preceding embodiments. To avoid repetitions, the method of Fig. 14 will be described referring to those embodiments.

At 1400, the method comprises setting a heater of a PCM switch device to a low first state having a low electrical resistance for heating the phase change material, in order to perform a set of reset operation. For example, in case the heater is provided as a pin diode, the diode may be forward biased, and when it is provided as a transistor-like structure, a control electrode may be controlled accordingly.

At 1401, the method comprises setting the heater to a high resistance second state having a high electrical resistance outside the heating, for example in an off state, on state or both. For example, in case of a pin diode this diode may be reversed biased, or a control electrode of a transistor-like structure may be controlled such that no conductive channel is formed.

The actions at 1400 and 1401 may be repeated in any order. For example, the heater may be set to the first, low resistance state at 1004 any time a set or reset operation and therefore a heating of the phase change material is to be performed.

Fig. 15 is a flow chart illustrating a method for manufacturing a PCM switch device according to an embodiment, for example for manufacturing any of the embodiments discussed above. Again, the method will be described referring to the previous Figures.

At 1500 the method comprises providing a phase change material. At 1501, the method comprises providing a heater which is switchable between a first state and a second state as explained above in thermal contact with the phase change material. It should be noted that the order of 1500 and 1501 may also be reversed such that the heater is first manufactured, followed by the phase change material. For example, in the embodiments discussed above, heater structures may first be formed by deposition, iron implantation and the like, and then the phase change material may be deposited.

Fig. 16 illustrates an application example of PCM switch devices according to embodiments for antenna tuning purposes. Fig. 16 illustrates an antenna structure 1600 including a so called feed point 1601 and a first aperture point 1602. Feed point 1601 is coupled to a shunt inductor $L_{shunt}$ and, for tuning purposes, may be selectively coupled via a first switch device $SW_1$ with a parallel circuit of an inductor $L_1$ and a capacitor $C_1$. Aperture point 1602 is coupled to an inductor $L_2$ and a capacitor $C_2$ as shown, which may be selectively coupled to ground via a switch device $SW_2$. Switch devices $SW_1$, $SW_2$ in an embodiment are implemented using PCM switch devices according to any of the above embodiments. In this way, a parasitic capacitance of switches $SW_1$, $SW_2$ is reduced, which otherwise could adversely affect the tuning behavior and radio frequency behavior.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims.

**Claims**

1. A phase change material switch device (10), comprising:

    a phase change material (11), and
    a heater device (12; 40, 41; 50, 51, 52; 60, 61, 62; 70-73; 92, 93, 96, 97; 1001-1004; 92A, 92B, 1200) thermally coupled to the phase change material (11),
    **characterized in that**
    the heater device (12; 40, 41; 50, 51, 52; 60, 61, 62; 70-73; 92, 93, 96, 97; 1001-1004; 92A, 92B, 1200) is configured to:

have a first electrical resistance in a first state where current is applied to the heater device (12; 40, 41; 50, 51, 52; 60, 61, 62; 70-73; 92, 93, 96, 97; 1001-1004; 92A, 92B, 1200) for heating the phase change material (11), and

have a second electrical resistance higher than the first electrical resistance in a second state outside heating phases of the heater device (12; 40, 41; 50, 51, 52; 60, 61, 62; 70-73; 92, 93, 96, 97; 1001-1004; 92A, 92B, 1200).

2. The phase change material switch device (10) of claim 1, wherein the second electrical resistance is at least 100 times higher than the first electrical resistance.

3. The phase change material switch device (10) of claim 1 or 2, wherein the first electrical resistance is 500 Ohm or less.

4. The phase change material switch device (10) of any one of claim 1 to 3, wherein the second electrical resistance is 1 kiloohm or higher.

5. The phase change switch device of any one of claims 1 to 4, further comprising at least one electrical conductor (13A, 13B) galvanically coupled to the phase change material (11), wherein a capacitance being configured to be caused by the heater device (12; 40, 41; 50, 51, 52; 60, 61, 62; 70-73; 92, 93, 96, 97; 1001-1004; 92A, 92B, 1200) is lower in the second state than in the first state.

6. The phase change material switch device (10) of any one of claim 1 to 5, further comprising an electrically insulating material (20) between the heater device (12; 40, 41; 50, 51, 52; 60, 61, 62; 70-73; 92, 93, 96, 97; 1001-1004; 92A, 92B, 1200) and the phase change material (11).

7. The phase change material switch device (10) of any one of claims 1 to 6, wherein the heater device (12; 40, 41; 50, 51, 52; 60, 61, 62; 70-73; 92, 93, 96, 97; 1001-1004; 92A, 92B, 1200) includes a semiconductor device configured to cause the first state and the second state.

8. The phase change material switch device (10) of claim 7, wherein the semiconductor device includes a pin diode, wherein the pin diode is configured to be forward biased in the first state and reverse biased in the second state.

9. The phase change material switch device (10) of claim 7 or 8, wherein the semiconductor device comprises a lightly doped or intrinsic semiconductor material provided in thermal contact with the heater device (12; 40, 41; 50, 51, 52; 60, 61, 62; 70-73; 92, 93, 96, 97; 1001-1004; 92A, 92B, 1200) and at least one heavily doped semiconductor or metal region in contact with the lightly doped or intrinsic semiconductor material.

10. The phase change material switch device (10) of claim 7, wherein the semiconductor device comprises a transistor, which is configured to be set to a switched off state in the second state

11. The phase change material switch device (10) of claim 10, wherein the transistor comprises a MOSFET.

12. The phase change material switch device (10) of claim 10 or 11, wherein the transistor comprises a transistor provided at least partially in a trench.

13. The phase change switch device (10) of any one of claims 1 to 12, wherein in a top view a part (40) of the heater device being configured to cause the second electrical resistance in the second state partially covers the same area as the phase change material (11), and contact regions (41) adjacent to the part (40) with lower resistance are outside an area covered by an amorphous region of the phase change material (11) in a switched off state of the phase change material switch device (10) and/or in a same area as at least one electrical conductor (13A, 13B) galvanically coupled to the phase change material (11).

14. A method of operating a phase change material switch device (10), the phase change material switch device (10) comprising a phase change material (11), and a heater device (12; 40, 41; 50, 51, 52; 60, 61, 62; 70-73; 92, 93, 96, 97; 1001-1004; 92A, 92B, 1200) thermally coupled to the phase change material (11), the method comprising:

switching a state of the phase change material switch device (10) by setting the heater device (12; 40, 41; 50, 51, 52; 60, 61, 62; 70-73; 92, 93, 96, 97; 1001-1004; 92A, 92B, 1200) to a first state with a first electrical resistance and providing current through the heater device (12; 40, 41; 50, 51, 52; 60, 61, 62; 70-73; 92, 93, 96, 97; 1001-1004; 92A, 92B, 1200) for heating the phase change material (11), and setting the heater device (12; 40, 41; 50, 51, 52; 60, 61, 62; 70-73; 92, 93, 96, 97; 1001-1004; 92A, 92B, 1200) to a second state with a second electrical resistance higher than the first electrical resistance outside heating phases of the heater device (12; 40, 41; 50, 51, 52; 60, 61, 62; 70-73; 92, 93, 96, 97; 1001-1004; 92A, 92B, 1200).

15. The method of claim 14, further comprising switching a radio frequency signal to the phase change material switch device (10).

**Patentansprüche**

1. Phasenwechselmaterialschaltvorrichtung (10), umfassend:

   ein Phasenwechselmaterial (11), und
   eine Heizervorrichtung (12; 40, 41; 50, 51, 52; 60, 61, 62; 70-73; 92, 93, 96, 97; 1001-1004; 92A, 92B, 1200), die thermisch mit dem Phasenwechselmaterial (11) gekoppelt ist, **dadurch gekennzeichnet, dass** die Heizervorrichtung (12; 40, 41; 50, 51, 52; 60, 61, 62; 70-73; 92, 93, 96, 97; 1001-1004; 92A, 92B, 1200) konfiguriert ist, um:

   einen ersten elektrischen Widerstand in einem ersten Zustand aufzuweisen, in dem Strom an die Heizervorrichtung (12; 40, 41; 50, 51, 52; 60, 61, 62; 70-73; 92, 93, 96, 97; 1001-1004; 92A, 92B, 1200) zum Erwärmen des Phasenwechselmaterials (11) angelegt wird, und
   einen zweiten elektrischen Widerstand aufzuweisen, der höher als der erste elektrische Widerstand in einem zweiten Zustand außerhalb von Erwärmungsphasen der Heizervorrichtung (12; 40, 41; 50, 51, 52; 60, 61, 62; 70-73; 92, 93, 96, 97; 1001-1004; 92A, 92B, 1200) ist.

2. Phasenwechselmaterialschaltvorrichtung (10) nach Anspruch 1, wobei der zweite elektrische Widerstand mindestens 100-mal höher als der erste elektrische Widerstand ist.

3. Phasenwechselmaterialschaltvorrichtung (10) nach Anspruch 1 oder 2, wobei der erste elektrische Widerstand 500 Ohm oder weniger beträgt.

4. Phasenwechselmaterialschaltvorrichtung (10) nach einem der Ansprüche 1 bis 3, wobei der zweite elektrische Widerstand 1 Kiloohm oder höher beträgt.

5. Phasenwechselmaterialschaltvorrichtung nach einem der Ansprüche 1 bis 4, ferner umfassend mindestens einen elektrischen Leiter (13A, 13B), der galvanisch mit dem Phasenwechselmaterial (11) gekoppelt ist, wobei eine Kapazität, die konfiguriert ist, um durch die Heizervorrichtung (12; 40, 41; 50, 51, 52; 60, 61, 62; 70-73; 92, 93, 96, 97; 1001-1004; 92A, 92B, 1200) verursacht zu werden, im zweiten Zustand niedriger als im ersten Zustand ist.

6. Phasenwechselmaterialschaltvorrichtung (10) nach einem der Ansprüche 1 bis 5, ferner umfassend ein elektrisch isolierendes Material (20) zwischen der Heizervorrichtung (12; 40, 41; 50, 51, 52; 60, 61, 62; 70-73; 92, 93, 96, 97; 1001-1004; 92A, 92B, 1200) und dem Phasenwechselmaterial (11).

7. Phasenwechselmaterialschaltvorrichtung (10) nach einem der Ansprüche 1 bis 6, wobei die Heizervorrichtung (12; 40, 41; 50, 51, 52; 60, 61, 62; 70-73; 92, 93, 96, 97; 1001-1004; 92A, 92B, 1200) eine Halbleitervorrichtung beinhaltet, die konfiguriert ist, um den ersten Zustand und den zweiten Zustand zu verursachen.

8. Phasenwechselmaterialschaltvorrichtung (10) nach Anspruch 7, wobei die Halbleitervorrichtung eine Pin-Diode beinhaltet, wobei die Pin-Diode konfiguriert ist, um im ersten Zustand vorwärts vorgespannt und im zweiten Zustand rückwärts vorgespannt zu sein.

9. Phasenwechselmaterialschaltvorrichtung (10) nach Anspruch 7 oder 8, wobei die Halbleitervorrichtung ein leicht dotiertes oder intrinsisches Halbleitermaterial umfasst, das in thermischem Kontakt mit der Heizervorrichtung (12; 40, 41; 50, 51, 52; 60, 61, 62; 70-73; 92, 93, 96, 97; 1001-1004; 92A, 92B, 1200) und mindestens einem stark dotierten Halbleiter- oder Metallbereich in Kontakt mit dem leicht dotierten oder intrinsischen Halbleitermaterial bereitgestellt ist.

10. Phasenwechselmaterialschaltvorrichtung (10) nach Anspruch 7, wobei die Halbleitervorrichtung einen Transistor umfasst, der konfiguriert ist, um im zweiten Zustand in einen ausgeschalteten Zustand versetzt zu werden.

11. Phasenwechselmaterialschaltvorrichtung (10) nach Anspruch 10, wobei der Transistor einen MOSFET umfasst.

12. Phasenwechselmaterialschaltvorrichtung (10) nach Anspruch 10 oder 11, wobei der Transistor einen Transistor umfasst, der zumindest teilweise in einem Graben bereitgestellt ist.

13. Phasenwechselmaterialschaltvorrichtung (10) nach einem der Ansprüche 1 bis 12, wobei in einer Draufsicht ein Teil (40) der Heizervorrichtung, der konfiguriert ist, um den zweiten elektrischen Widerstand im zweiten Zustand zu verursachen, teilweise den gleichen Bereich wie das Phasenwechselmaterial (11) bedeckt, und Kontaktbereiche (41) neben dem Teil (40) mit niedrigerem Widerstand außerhalb eines Bereichs liegen, der von einem amorphen Bereich des Phasenwechselmaterials (11) in einem ausgeschalteten Zustand der Phasenwechselmaterialschaltvorrichtung (10) und/oder in einem gleichen Bereich wie mindestens ein elektrischer Leiter (13A, 13B), der galvanisch mit dem Phasenwechselmaterial (11) gekoppelt ist, bedeckt ist.

14. Verfahren zum Betreiben einer Phasenwechselmaterialschaltvorrichtung (10), wobei die Phasenwechselmaterialschaltvorrichtung (10) ein Phasenwechselmaterial (11) und eine Heizervorrichtung (12; 40, 41; 50, 51, 52; 60, 61, 62; 70-73; 92, 93, 96, 97; 1001-1004; 92A, 92B, 1200), die thermisch mit dem Phasenwechselmaterial (11) gekoppelt ist, umfasst, wobei das Verfahren Folgendes umfasst:

Schalten eines Zustands der Phasenwechselmaterialschaltvorrichtung (10) durch Versetzen der Heizervorrichtung (12; 40, 41; 50, 51, 52; 60, 61, 62; 70-73; 92, 93, 96, 97; 1001-1004; 92A, 92B, 1200) in einen ersten Zustand mit einem ersten elektrischen Widerstand und Bereitstellen von Strom durch die Heizervorrichtung (12; 40, 41; 50, 51, 52; 60, 61, 62; 70-73; 92, 93, 96, 97; 1001-1004; 92A, 92B, 1200) zum Erwärmen des Phasenwechselmaterials (11), und Versetzen der Heizervorrichtung (12; 40, 41; 50, 51, 52; 60, 61, 62; 70-73; 92, 93, 96, 97; 1001-1004; 92A, 92B, 1200) in einen zweiten Zustand mit einem zweiten elektrischen Widerstand, der außerhalb von Erwärmungsphasen der Heizervorrichtung (12; 40, 41; 50, 51, 52; 60, 61, 62; 70-73; 92, 93, 96, 97; 1001-1004; 92A, 92B, 1200) höher als der erste elektrische Widerstand ist.

15. Verfahren nach Anspruch 14, ferner umfassend das Schalten eines Hochfrequenzsignals zu der Phasenwechselmaterialschaltvorrichtung (10).

**Revendications**

1. Un dispositif (10) de commutation à matériau à changement de phase, comprenant :

un matériau (11) à changement de phase et un dispositif (12 ; 40, 41 ; 50, 51, 52 ; 60, 61, 62 ; 70-73 ; 92, 93, 96, 97 ; 1001-1004 ; 92A, 92B, 1200) de chauffage couplé thermiquement au matériau (11) à changement de phase, **caractérisé en ce que** le dispositif (12 ; 40, 41 ; 50, 51, 52 ; 60, 61, 62 ; 70-73 ; 92, 93, 96, 97 ; 1001-1004 ; 92A, 92B, 1200) de chauffage est configuré pour :

avoir une première résistance électrique dans un premier état où du courant est appliqué au dispositif (12 ; 40, 41 ; 50, 51, 52 ; 60, 61, 62 ; 70-73 ; 92, 93, 96, 97 ; 1001-1004 ; 92A, 92B, 1200) de chauffage pour chauffer le matériau (11) à changement de phase, et

avoir une deuxième résistance électrique plus grande que la première résistance électrique dans un deuxième état en-dehors des phases de chauffage du dispositif (12 ; 40, 41 ; 50, 51, 52 ; 60, 61, 62 ; 70-73 ; 92, 93, 96, 97 ; 1001-1004 ; 92A, 92B, 1200) de chauffage.

2. Le dispositif (10) de commutation à matériau à changement de phase de la revendication 1, dans lequel la deuxième résistance électrique est au moins 100 fois plus grande que la première résistance électrique.

3. Le dispositif (10) de commutation à matériau à changement de phase de la revendication 1 ou 2, dans lequel la première résistance électrique est inférieure ou égale à 500 Ohm.

4. Le dispositif (10) de commutation à matériau à changement de phase de l'une quelconque des revendications 1 à 3, dans lequel la deuxième résistance électrique est supérieure ou égale à 1 kiloohm.

5. Le dispositif de commutation à matériau à changement de phase de l'une quelconque des revendications 1 à 4, comprenant en outre au moins un conducteur (13A, 13B) électrique couplé galvaniquement au matériau (11) à changement de phase, dans lequel une capacité configurée pour être donnée par le dispositif (12 ; 40, 41 ; 50, 51, 52 ; 60, 61, 62 ; 70-73 ; 92, 93, 96, 97 ; 1001-1004 ; 92A, 92B, 1200) de chauffage est plus petite dans le deuxième état que dans le premier état.

6. Le dispositif (10) de commutation à matériau à changement de phase de l'une quelconque des revendications 1 à 5, comprenant en outre un matériau (20) isolant électriquement entre le dispositif (12 ; 40, 41 ; 50, 51, 52 ; 60, 61, 62 ; 70-73 ; 92, 93, 96, 97 ; 1001-1004 ; 92A, 92B, 1200) de chauffage et le matériau (11) à changement de phase.

7. Le dispositif (10) de commutation à matériau à changement de phase de l'une quelconque des revendications 1 à 6, dans lequel le dispositif (12 ; 40, 41 ; 50, 51, 52 ; 60, 61, 62 ; 70-73 ; 92, 93, 96, 97 ; 1001-1004 ; 92A, 92B, 1200) de chauffage comprend un dispositif à semiconducteur configuré pour donner le premier état et le deuxième état.

**8.** Le dispositif (10) de commutation à matériau à changement de phase de la revendication 7, dans lequel le dispositif à semiconducteur comprend une diode pin, dans lequel la diode pin est configurée pour être polarisée dans le sens direct dans le premier état et être polarisée dans le sens inverse dans le deuxième état.

**9.** Le dispositif (10) de commutation à matériau à changement de phase de la revendication 7 ou 8, dans lequel le dispositif à semiconducteur comprend un matériau semiconducteur dopé légèrement ou intrinsèque en contact thermique avec le dispositif (12 ; 40, 41 ; 50, 51, 52 ; 60, 61, 62 ; 70-73 ; 92, 93, 96, 97 ; 1001-1004 ; 92A, 92B, 1200) de chauffage et au moins un semiconducteur dopé fortement ou une région métallique en contact avec le matériau semiconducteur dopé légèrement ou intrinsèque.

**10.** Le dispositif (10) de commutation à matériau à changement de phase de la revendication 7, dans lequel le dispositif à semiconducteur comprend un transistor, qui est configuré pour être mis à un état bloqué dans le deuxième état.

**11.** Le dispositif (10) de commutation à matériau à changement de phase de la revendication 10, dans lequel le transistor comprend un MOSFET.

**12.** Le dispositif (10) de commutation à matériau à changement de phase de la revendication 10 ou 11, dans lequel le transistor comprend un transistor prévu au moins en partie dans une tranchée.

**13.** Le dispositif (10) de commutation à matériau à changement de phase de l'une quelconque des revendications 1 à 12, dans lequel dans une vue de dessus une partie (40) du dispositif de chauffage étant configurée pour faire que la deuxième résistance électrique dans le deuxième état recouvre partiellement la même surface que le matériau (11) à changement de phase, et que des régions (41) de contact contiguës à la partie (40) ayant une résistance assez petite soient à l'extérieur d'une zone recouverte par une région amorphe du matériau (11) à changement de phase dans un état ouvert du dispositif (10) de commutation à matériau à changement de phase et/ou dans une même zone qu'au moins un conducteur (13A, 13B) électrique couplé galvaniquement au matériau (11) à changement de phase.

**14.** Un procédé pour faire fonctionner un dispositif (10) de commutation à matériau à changement de phase, le dispositif (10) de commutation à matériau à changement de phase comprenant un matériau (11) à changement de phase et un dispositif (12 ; 40, 41 ; 50, 51, 52 ; 60, 61, 62 ; 70-73 ; 92, 93, 96, 97 ; 1001-1004 ; 92A, 92B, 1200) de chauffage couplé thermiquement au matériau (11) à changement de phase, le procédé comprenant :

> commuter un état du dispositif (10) de commutation à matériau à changement de phase en mettant le dispositif (12 ; 40, 41 ; 50, 51, 52 ; 60, 61, 62 ; 70-73 ; 92, 93, 96, 97 ; 1001-1004 ; 92A, 92B, 1200) de chauffage dans un premier état ayant une première résistance électrique et faire passer du courant dans le dispositif (12 ; 40, 41 ; 50, 51, 52 ; 60, 61, 62 ; 70-73 ; 92, 93, 96, 97 ; 1001-1004 ; 92A, 92B, 1200) de chauffage pour chauffer le matériau (11) à changement de phase, et
> mettre le dispositif (12 ; 40, 41 ; 50, 51, 52 ; 60, 61, 62 ; 70-73 ; 92, 93, 96, 97 ; 1001-1004 ; 92A, 92B, 1200) de chauffage à un deuxième état ayant une deuxième résistance électrique plus grande que la première résistance électrique en-dehors des phases de chauffage du dispositif (12 ; 40, 41 ; 50, 51, 52 ; 60, 61, 62 ; 70-73 ; 92, 93, 96, 97 ; 1001-1004 ; 92A, 92B, 1200) de chauffage.

**15.** Le procédé de la revendication 14, comprenant en outre commuter un signal de fréquence radio au dispositif (10) de commutation à matériau à changement de phase.

Fig. 1

Fig. 2A

Fig. 2B

Fig. 3

Fig. 4A

Fig. 4B

13A  50  p+  51  11  13B

i

n+

52

Fig. 5A

13A  13B

11
20
i
51

Fig. 5B

60  61  62

13A  13B

p+  i  n+
11

Fig. 6A

13A  13B

11
20
p+  i  n+
60  61  62

Fig. 6B

Fig. 6C

Fig. 7A

Fig. 7B

Fig. 8

Fig. 9A

Fig. 9B

EP 4 261 905 B1

Fig. 10A

Fig. 10B

Fig. 11A

Fig. 11B

17

Fig. 12A

Fig. 12B

Fig. 13

Set heater to low resistance state for heating ⟋1400

Set heater to high resistance state outside heating ⟋1401

## Fig. 14

Provide phase change material ⟋1500

Provide switchable heater ⟋1501

## Fig. 15

## Fig. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9917104 B1
- US 10461253 B1
- US 20100163832 A1